# EUROPEAN PATENT APPLICATION

(11) **EP 4 766 077 A1**
(43) Date of publication of application: **24.06.2026**
(21) Application number: 25211356.8
(22) Date of filing: 27.10.2025
(51) Int. Cl.: H10D 30/01, H10D 30/00, H10D 62/13, H10D 64/01, H10W 40/25, H10D 62/10, H10D 84/01, H10W 40/20, H10D 64/23, H10D 84/83, B82Y 10/00

(54) **THERMAL MANAGEMENT STRUCTURES INTEGRATED IN SEMICONDUCTOR DEVICES**

(30) Priority: 19.12.2024 US 202418987971
(71) Applicant: Intel Corporation, Santa Clara, CA 95054 (US)
(72) Inventor: Pantuso, Daniel, Portland OR, 97229 (US); Metz, Matthew V., Portland, OR, 97229 (US); Kobrinsky, Mauro J., Portland, OR, 97229 (US); Ramayya, Edwin B., Beaverton, OR, 97007 (US); Jiang, Lei, Camas, WA, 98607 (US); Phan, Anh, Beaverton, OR, 97997 (US); Landon, Colin D., Portland, OR, 97229 (US); D'Silva, Joseph, Hillsboro, OR, 97124 (US); Mills, Shaun, Hillsboro, OR, 97124 (US); Mannebach, Ehren, Beaverton, OR, 97997 (US); Sen Gupta, Arnab, Hillsboro, OR, 97123 (US)
(74) Representative: Samson & Partner Patentanwälte mbB

(57) **Abstract**

Techniques are provided herein to form semiconductor devices with thermal management structures designed to provide additional heat dissipation paths. A semiconductor device includes a gate structure around or otherwise on a semiconductor region that extends from a source region to a drain region. In one example, a subfin region beneath the semiconductor region is removed and replaced with a material having a thermal conductivity of at least 1.5 W/m·K. In another example, a material layer is formed between conductive contacts on the top surfaces of the source and drain regions that has a thermal conductivity of at least 1.5 W/m·K. In another example, the conductive contacts extend through at least 50% of an entire height of the source and drain regions to provide an enhanced thermal path. Any of the above-mentioned structures may also be combined in one or more devices to provide multiple different thermal management structures.

## Description

### BACKGROUND

As integrated circuits continue to scale downward in size, a number of challenges arise. For instance, reducing the size of memory and logic cells is becoming increasingly more difficult, as is reducing device spacing at the device layer. As transistors are packed more densely, parasitic effects caused by heat can increasingly impact the device operation in an undesirable way. Accordingly, there remain a number of non-trivial challenges with respect to forming semiconductor devices.

### BRIEF DESCRIPTION OF THE DRAWINGS

Figures 1A and 1B are cross-sectional views of some semiconductor devices with thermal management structures, in accordance with some embodiments of the present disclosure.
Figures 2A and 2B are cross-sectional views that illustrate a stage in an example process for forming semiconductor devices that include thermal management structures, in accordance with some embodiments of the present disclosure.
Figures 3A and 3B are cross-sectional views that illustrate another stage in the example process for forming semiconductor devices that include thermal management structures, in accordance with some embodiments of the present disclosure.
Figures 4A and 4B are cross-sectional views that illustrate another stage in the example process for forming semiconductor devices that include thermal management structures, in accordance with some embodiments of the present disclosure.
Figures 5A and 5B are cross-sectional views that illustrate another stage in the example process for forming semiconductor devices that include thermal management structures, in accordance with some embodiments of the present disclosure.
Figures 6A and 6B are cross-sectional views that illustrate another stage in the example process for forming semiconductor devices that include thermal management structures, in accordance with some embodiments of the present disclosure.
Figures 7A and 7B are cross-sectional views that illustrate another stage in the example process for forming semiconductor devices that include thermal management structures, in accordance with some embodiments of the present disclosure.
Figures 8A and 8B are cross-sectional views that illustrate another stage in the example process for forming semiconductor devices that include thermal management structures, in accordance with some embodiments of the present disclosure.
Figures 9A and 9B are cross-sectional views that illustrate another stage in the example process for forming semiconductor devices that include thermal management structures, in accordance with some embodiments of the present disclosure.
Figures 10A and 10B are cross-sectional views that illustrate another stage in the example process for forming semiconductor devices that include thermal management structures, in accordance with some embodiments of the present disclosure.
Figures 11A and 11B are cross-sectional views that illustrate another stage in the example process for forming semiconductor devices that include thermal management structures, in accordance with some embodiments of the present disclosure.
Figures 12A and 12B are cross-sectional views that illustrate another stage in the example process for forming semiconductor devices that include thermal management structures, in accordance with some embodiments of the present disclosure.
Figures 13A and 13B are cross-sectional views that illustrate another stage in the example process for forming semiconductor devices that include thermal management structures, in accordance with some embodiments of the present disclosure.
Figures 14A and 14B are cross-sectional views that illustrate another stage in the example process for forming semiconductor devices that include thermal management structures, in accordance with some embodiments of the present disclosure.
Figures 15A and 15B are cross-sectional views that illustrate another stage in the example process for forming semiconductor devices that include thermal management structures, in accordance with some embodiments of the present disclosure.
Figure 16 illustrates a cross-sectional view of a chip package containing one or more semiconductor dies, in accordance with some embodiments of the present disclosure.
Figure 17 illustrates a computing system including one or more integrated circuits, as variously described herein, in accordance with an embodiment of the present disclosure.

Although the following Detailed Description will proceed with reference being made to illustrative embodiments, many alternatives, modifications, and variations thereof will be apparent in light of this disclosure. As will be further appreciated, the figures are not necessarily drawn to scale or intended to limit the present disclosure to the specific configurations shown. For instance, while some figures generally indicate perfectly straight lines, right angles, and smooth surfaces, an actual implementation of an integrated circuit structure may have less than perfect straight lines, right angles (e.g., some features may have tapered sidewalls and/or rounded corners), and some features may have surface topology or otherwise be non-smooth, given real world limitations of the processing equipment and techniques used.

### DETAILED DESCRIPTION

Techniques are provided herein to form semiconductor devices with thermal management structures designed to provide additional heat dissipation paths. The techniques can be used in any number of integrated circuit applications and are particularly useful with respect to non-planar transistors that have a subfin portion, such as finFETs or gate-all-around transistors (e.g., ribbonFETs and nanowire FETs). A semiconductor device includes a gate structure around or otherwise on a semiconductor region. The semiconductor region can be, for example, a fin of semiconductor material that extends from a source region to a drain region, or one or more nanowires or nanoribbons or nanosheets of semiconductor material that extend from a source region to a drain region. A lower end of the fin of semiconductor material includes a subfin adjacent to a dielectric layer that acts as shallow trench isolation (STI) between semiconductor devices. In one example, the subfin is removed and replaced with a subregion directly beneath the semiconductor region and adjacent to the dielectric layer, wherein the subregion includes a material having a thermal conductivity larger than conventional silicon dioxide (e.g., having a thermal conductivity of at least 1.5 W/m·K, at least 20 W/m·K, or at least 300 W/m·K). In another example, a material layer may be formed between conductive contacts on the top surfaces of the source and drain regions, wherein the material layer has a thermal conductivity larger than conventional silicon dioxide (e.g., having a thermal conductivity of at least 1.5 W/m·K or at least 20 W/m·K). In another example, the conductive contacts extend from the top surface, from the bottom surface, or from both top and bottom surfaces of the source or drain regions through at least 50% of an entire height of the source and drain regions to provide an enhanced thermal path for heat transport through the epi regions. Any of the above-mentioned structures may also be combined in one or more devices to provide multiple different thermal management structures. Materials having thermal conductivity different than those described above may also be used, depending on the given application. Numerous variations and embodiments will be apparent in light of this disclosure.

### General Overview

As previously noted above, there remain a number of non-trivial challenges with respect to integrated circuit fabrication. In more detail, as devices become smaller and more densely packed, heat dissipation from the devices increasingly becomes a challenge. In some devices, airgaps are employed between source/drain regions or generally between any conductive structures to reduce parasitic capacitance. However, the inclusion of airgaps can also cause an increase in heat retention around the devices, as the airgaps are poor thermal conductors. Even without airgaps, semiconductor devices can benefit from enhanced thermal management designs since the performance of the devices suffer as the heat increases.

Thus, techniques are provided herein to form one or more thermal management structures with semiconductor devices to enhance heat spreading. According to some embodiments, the thermal management structures include regions adjacent to the semiconductor devices that include materials having a relatively high thermal conductivity. For example, subfin regions of the devices include semiconductor material that is sometimes replaced with a low thermally conductive material, such as silicon dioxide. According to some embodiments, these subfin regions are instead replaced with a material having a relatively high thermal conductivity, such as a thermal conductivity of at least 1.5 W/m·K, at least 20 W/m·K, or at least 300 W/m·K. Some example non-metal materials having this higher thermal conductivity include silicon carbide, diamond, aluminum nitride, or boron nitride. In some examples, a metal such as copper can also be used to replace the subfin region. The presence of the high thermal conductivity material can enable more efficient heat conduction away from the semiconductor devices through backside and/or frontside interconnect layers.

Another thermal management structure includes a material layer present between conductive contacts on the top surfaces of adjacent source or drain regions, according to some embodiments. Similar to the discussion above, this area between contacts is typically filled with a low thermal conductivity material, such as silicon dioxide. However, according to some embodiments, the material layer formed between the contacts has a high thermal conductivity, for example, of at least 1.5 W/m·K, at least 10 W/m·K, or at least 20 W/m·K. Some example non-metal materials having this higher thermal conductivity include silicon nitride, aluminum oxide, silicon carbide, diamond, aluminum nitride, or boron nitride. In some examples, the material layer formed between the contacts may have a thermal conductivity of at least 300 W/m·K.

According to some embodiments, the contacts on the source or drain regions may extend deep into the source or drain regions to provide a more thermally conductive path through the source or drain regions. The contacts may extend, for example, through at least 50% of the entire height of the source or drain regions. In some examples, the contacts extend through an entire height of the source or drain regions.

According to an embodiment, an integrated circuit includes a semiconductor region extending from a source or drain region in a first direction, a gate structure extending over the semiconductor region in a second direction different from the first direction, a dielectric layer beneath the gate structure, and a subregion beneath the semiconductor region. The subregion extends through at least a portion of a thickness of the dielectric layer. The subregion includes a material having a thermal conductivity of, for example, at least 1.5 W/m·K, at least 20 W/m·K, or at least 300 W/m·K.

According to another embodiment, an integrated circuit includes a first semiconductor region extending from a first source or drain region in a first direction, a second semiconductor region extending from a second source or drain region in the first direction, a gate structure extending over the first semiconductor region and/or the second semiconductor region in a second direction different from the first direction, a first contact on a top surface of the first source or drain region, a second contact on a top surface of the second source or drain region, and a material layer between the first contact and the second contact. The second source or drain region is adjacent to the first source or drain region along the second direction. The material layer has a high thermal conductivity of, for example, at least 1.5 W/m·K, at least 10 W/m·K, or at least 20 W/m·K.

According to another embodiment, an integrated circuit includes a first semiconductor region extending from a first source or drain region in a first direction, a second semiconductor region extending from a second source or drain region in the first direction, a gate structure extending over the first semiconductor region and/or the second semiconductor region in a second direction different from the first direction, a dielectric layer beneath the gate structure, a first contact over a top surface of the first source or drain region, a second contact over a top surface of the second source or drain region, a material layer between the first contact and the second contact along the second direction, and a subregion beneath the first semiconductor region or the second semiconductor region. The second source or drain region is adjacent to the first source or drain region along the second direction. In an example, the first contact extends through at least 50% of an entire height of the first source or drain region and/or the second contact extends through at least 50% of an entire height of the second source or drain region. The material layer has a high thermal conductivity of, for example, at least 1.5 W/m·K, at least 10 W/m·K, or at least 20 W/m·K. The subregion extends through at least a portion of a thickness of the dielectric layer and includes a material having a high thermal conductivity of, for example, at least 1.5 W/m·K, at least 20 W/m·K, or at least 300 W/m·K.

The techniques can be used with any type of non-planar transistors, including finFETs (sometimes called tri-gate transistors), nanowire and nanoribbon transistors (sometimes called gate-all-around transistors), or forksheet transistors, to name a few examples. The source and drain regions can be, for example, doped portions of a given fin or substrate, or epitaxial regions that are deposited during an etch-and-replace source/drain forming process. The dopant-type in the source and drain regions will depend on the polarity of the corresponding transistor. The gate structure can be implemented with a gate-first process or a gate-last process (sometimes called a replacement metal gate, or RMG, process). Any number of semiconductor materials can be used in forming the transistors, such as group IV materials (e.g., silicon, germanium, silicon germanium) or group III-V materials (e.g., gallium arsenide, indium gallium arsenide).

Use of the techniques and structures provided herein may be detectable using tools such as electron microscopy including scanning/transmission electron microscopy (SEM/TEM), scanning transmission electron microscopy (STEM), nano-beam electron diffraction (NBD or NBED), and reflection electron microscopy (REM); composition mapping; x-ray crystallography or diffraction (XRD); energy-dispersive x-ray spectroscopy (EDX); secondary ion mass spectrometry (SIMS); time-of-flight SIMS (ToF-SIMS); atom probe imaging or tomography; local electrode atom probe (LEAP) techniques; 3D tomography; or high resolution physical or chemical analysis, to name a few suitable example analytical tools. For instance, in some example embodiments, such tools may indicate the presence of a high thermal conductivity material (e.g., silicon carbide, diamond, aluminum nitride, or boron nitride) in subregions beneath the semiconductor channels of any number of devices. In another example, such tools may indicate the presence of another high thermal conductivity material (e.g., silicon nitride, aluminum oxide, silicon carbide, diamond, aluminum nitride, or boron nitride) between adjacent source/drain contacts. The high-thermal conductivity material may abut each of the adjacent source/drain contacts.

It should be readily understood that the meaning of "above" and "over" in the present disclosure should be interpreted in the broadest manner such that "above" and "over" not only mean "directly on" something but also include the meaning of over something with an intermediate feature or a layer therebetween. Further, spatially relative terms, such as "beneath," "below," "lower," "above," "upper," "top," "bottom," and the like, may be used herein for ease of description to describe one element or feature's relationship to another element (s) or feature (s) as illustrated in the figures. The spatially relative terms are intended to encompass different orientations of the device in use or operation in addition to the orientation depicted in the figures. The apparatus may be otherwise oriented (rotated 90 degrees or at other orientations) and the spatially relative descriptors used herein may likewise be interpreted accordingly.

As used herein, the term "layer" refers to a material portion including a region with a thickness. A monolayer is a layer that consists of a single layer of atoms of a given material. A layer can extend over the entirety of an underlying or overlying structure, or may have an extent less than the extent of an underlying or overlying structure. Further, a layer can be a region of a homogeneous or inhomogeneous continuous structure, with the layer having a thickness less than the thickness of the continuous structure. For example, a layer can be located between any pair of horizontal planes between, or at, a top surface and a bottom surface of the continuous structure. A layer can extend horizontally, vertically, and/or along a tapered surface. A layer can be conformal to a given surface (whether flat or curvilinear) with a relatively uniform thickness across the entire layer. A layer may partially or completely fill a given recess or space or volume. A space or volume that is at least partially within a given layer and devoid of any solid fill materials may be referred to herein as an airgap or a void (used interchangeably herein). Such an airgap or void may be filled with one or more gasses (e.g., oxygen, nitrogen, air, to name a few examples), or be devoid of any gases.

Materials that are "compositionally different" or "compositionally distinct" as used herein refers to two materials that have different chemical compositions. This compositional difference may be, for instance, by virtue of an element that is in one material but not the other (e.g., SiGe is compositionally different than silicon), or by way of one material having all the same elements as a second material but at least one of those elements is intentionally provided at a different concentration in one material relative to the other material (e.g., SiGe having 70 atomic percent germanium is compositionally different than from SiGe having 25 atomic percent germanium). In addition to such chemical composition diversity, the materials may also have distinct dopants (e.g., gallium and magnesium) or the same dopants but at differing concentrations. In still other embodiments, compositionally distinct materials may further refer to two materials that have different crystallographic orientations. For instance, (110) silicon is compositionally distinct or different from (100) silicon. Creating a stack of different orientations could be accomplished, for instance, with blanket wafer layer transfer. If two materials are elementally different, then one of the materials has an element that is not in the other material.

### Architecture

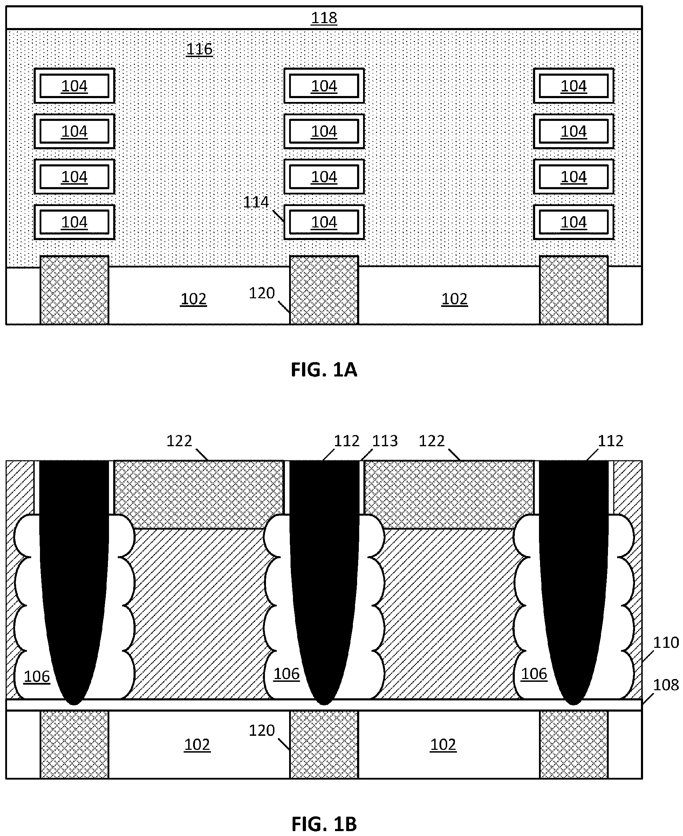

Figure 1A is a cross-sectional view taken across the gate trench of three example semiconductor devices, according to an embodiment of the present disclosure. Figure 1B is another cross-sectional view taken across the source/drain trench adjacent to the gate trench either into or out of the page of Figure 1A. Each of the semiconductor devices may be, for example, non-planar metal oxide semiconductor (MOS) transistors, such as tri-gate (e.g., finFET) or gate-all-around (GAA) transistors, although other transistor topologies and types could also benefit from the techniques provided herein. The illustrated example embodiments use the GAA structure. The various illustrated semiconductor devices represent a portion of an integrated circuit that may contain any number of similar semiconductor devices.

As can be seen, the semiconductor devices may be formed over a dielectric base layer 102. In some embodiments, a lower portion of (or all of) the substrate beneath dielectric base layer 102 is removed and replaced with one or more backside interconnect layers to form, for example, backside signal and power routing, during a backside process. Dielectric base layer 102 may represent any number of deposited dielectric materials, and may include different dielectric materials such as silicon dioxide, silicon oxynitride, silicon nitride, and/or silicon oxycarbonitride.

Each of the semiconductor devices includes one or more corresponding nanoribbons 104 that extend parallel to one another along a first direction between corresponding source or drain regions 106. Accordingly, each set of nanoribbons 104 extends in the first direction (into and out of the page) between a corresponding set of source or drain regions 106. Nanoribbons 104 are one example of semiconductor regions or semiconductor bodies that extend between source or drain regions 106. According to some embodiments, nanoribbons 104 (or other semiconductor bodies) extend between source or drain regions 106 in the first direction to provide an active region (sometimes called channel region) for a transistor (e.g., the semiconductor region beneath the gate). It should be understood that the source or drain regions 106 illustrated in the cross-section of Figure 1B are only along one side of nanoribbons 104 (e.g., out of the page of FIG. 1A) and that similar source or drain regions may be present along the opposite side of nanoribbons 104.

The term nanoribbon may also encompass other similar shapes such as nanowires or nanosheets. The semiconductor material of nanoribbons 104 may be formed from a semiconductor substrate. In some embodiments, the semiconductor devices may each include semiconductor regions in the shape of fins that can be, for example, native to the substrate (formed from the substrate itself), such as silicon fins etched from a bulk silicon substrate. Alternatively, the fins can be formed of material deposited onto an underlying substrate. In one such example case, a blanket layer of silicon germanium (SiGe) can be deposited onto a silicon substrate, and then patterned and etched to form a plurality of SiGe fins extending from that substrate. In another such example, non-native fins can be formed in a so-called aspect ratio trapping based process, where native fins are etched away so as to leave fin-shaped trenches which can then be filled with an alternative semiconductor material (e.g., group IV or III-V material). In still other embodiments, the fins include alternating layers of material (e.g., alternating layers of silicon and SiGe) that facilitate forming of the illustrated nanoribbons 104 during a gate forming process where one type of the alternating layers is selectively etched away so as to liberate the other type of alternating layers within the channel region, so that a gate-all-around (GAA) process can then be carried out. Again, the alternating layers can be blanket deposited and then etched into fins or deposited into fin-shaped trenches.

According to some embodiments, source or drain regions 106 are epitaxial regions that are provided using an etch-and-replace process. In other embodiments source or drain regions 106 could be, for example, implantation-doped native portions of the semiconductor fins or substrate. Any semiconductor materials suitable for source and drain regions can be used (e.g., group IV and group III-V semiconductor materials). The composition and doping of source or drain regions 106 may be the same or different, depending on the polarity of the transistors. In an example, for instance, one transistor is a p-type MOS (PMOS) transistor, and another transistor is an n-type MOS (NMOS) transistor. As such, a given source or drain region 106 may have a different dopant type (n or p) compared to any other source or drain region 106 along a given source/drain trench. Any number of source or drain configurations and materials can be used.

According to some embodiments, a lower dielectric layer 108 exists beneath source or drain regions 106 within the source/drain trench. Lower dielectric layer 108 can include any suitable dielectric material, such as silicon dioxide or silicon nitride or silicon oxynitride. According to some embodiments, another dielectric fill 110 is provided around and/or over portions of source or drain regions 106 along the source/drain trench after epitaxial formation of the source/drain regions is complete. Dielectric fill 110 may be any suitable dielectric material, although in some embodiments, dielectric fill 110 includes the same dielectric material within dielectric base layer 102 or lower dielectric layer 108. In one example, each of dielectric fill 110, lower dielectric layer 108, and dielectric base layer 102 includes silicon dioxide. In some examples, an airgap may be formed within dielectric fill 110 between adjacent source or drain regions 106 to reduce parasitic capacitance between the source or drain regions.

According to some embodiments, any number of conductive contacts 112 may be formed on corresponding source or drain regions 106. According to some embodiments, conductive contacts 112 may be any suitably conductive material such as tungsten (W). Other conductive materials may include copper (Cu), ruthenium (Ru), cobalt (Co), titanium (Ti), molybdenum (Mo), or any alloys thereof. According to some embodiments, any number of conductive contacts 112 extend through at least a portion of the total height of source or drain regions 106. In the illustrated example, conductive contacts 112 extend through the entire height of source or drain regions 106. In some examples, conductive contacts 112 extend through at least 50% of the entire height of source or drain regions 106. According to some embodiments, a dielectric liner 113 is present on sidewall portions of conductive contacts 112. In some examples, dielectric liner 113 is present on the sidewalls of conductive contacts 112 that are above a top surface of source or drain regions 106. Dielectric liner 113 may have a thickness, for example, between about 1 nm and about 3 nm, and can be any suitable dielectric material, such a silicon nitride or silicon oxynitride.

According to some embodiments, a gate structure extends over nanoribbons 104 of each semiconductor device along a second direction across the page of Figure 1A. The gate structure includes a gate dielectric 114 and a gate electrode 116. Gate dielectric 114 represents any number of dielectric layers present between nanoribbons 104 and gate electrode 116. Gate dielectric 114 may also be present on the surfaces of other structures within the gate trench, such as on a surface of dielectric base layer 102. Gate dielectric 114 may include any suitable gate dielectric material(s). In some embodiments, gate dielectric 114 includes a layer of native oxide material (e.g., silicon dioxide) on the nanoribbons or other semiconductor regions making up the channel region of the devices, and a layer of high-k dielectric material (e.g., hafnium oxide) on the native oxide.

Gate electrode 116 may represent any number of conductive layers, such as any metal, metal alloy, or doped polysilicon layers. In some embodiments, gate electrode 116 includes one or more workfunction metals around nanoribbons 104. In some embodiments, one of the semiconductor devices is a p-channel device that includes a workfunction metal having titanium around its nanoribbons and another semiconductor device is an n-channel device that includes a workfunction metal having tungsten around its nanoribbons. Gate electrode 116 may also include a fill metal or other conductive material around the workfunction metals to provide the whole gate electrode structure. In some embodiments, a gate cap 118 may be provided on a top surface of gate electrode 116 within the gate trench. Gate cap 118 may be any suitable dielectric material, such as silicon oxynitride, silicon nitride, or silicon oxycarbonitride.

According to some embodiments, subregions 120 directly beneath nanoribbons 104 and source or drain regions 106 may include a material having a relatively high thermal conductivity. Subregions 120 may be formed within backside cavities that are left behind following the removal of semiconductor subfin regions from the backside of the structure, as will be discussed in more detail herein. Subregions 120 may include a material having a high thermal conductivity of at least 1.5 W/m·K, at least 20 W/m·K, or of at least 300 W/m·K. Some example materials having a thermal conductivity of at least 300 W/m·K include silicon carbide, diamond, aluminum nitride, or boron nitride. The high thermal conductivity material may substantially fill an entirety of subregions 120. In some examples, a top surface of subregions 120 is above a top surface of dielectric base layer 102 within the gate trench while a bottom surface of subregions 120 is substantially coplanar with a bottom surface of dielectric base layer 102.

According to some embodiments, a material layer 122 is formed between the top portions of adjacent conductive contacts 112. Material layer 122 may be different from dielectric fill 110 and may have a high thermal conductivity of at least 1.5 W/m·K, at least 10 W/m·K, or at least 20 W/m·K. Some example materials for material layer 122 include silicon carbide, diamond, aluminum nitride, boron nitride, silicon nitride, or aluminum oxide. In some examples, material layer 122 has a thermal conductivity of at least 300 W/m·K. In some examples, material layer 122 extends the entire length between the adjacent contacts 112 along the second direction. In some examples, material layer 122 extends the entire length between dielectric liner 113 on the outside surfaces of the adjacent contacts 112 along the second direction. A portion of material layer 122 may extend below a top surface of source or drain regions 106. A top surface of material layer 122 may be polished using, for example, chemical mechanical polishing (CMP) to be substantially coplanar with a top surface of contacts 112.

### Fabrication Methodology

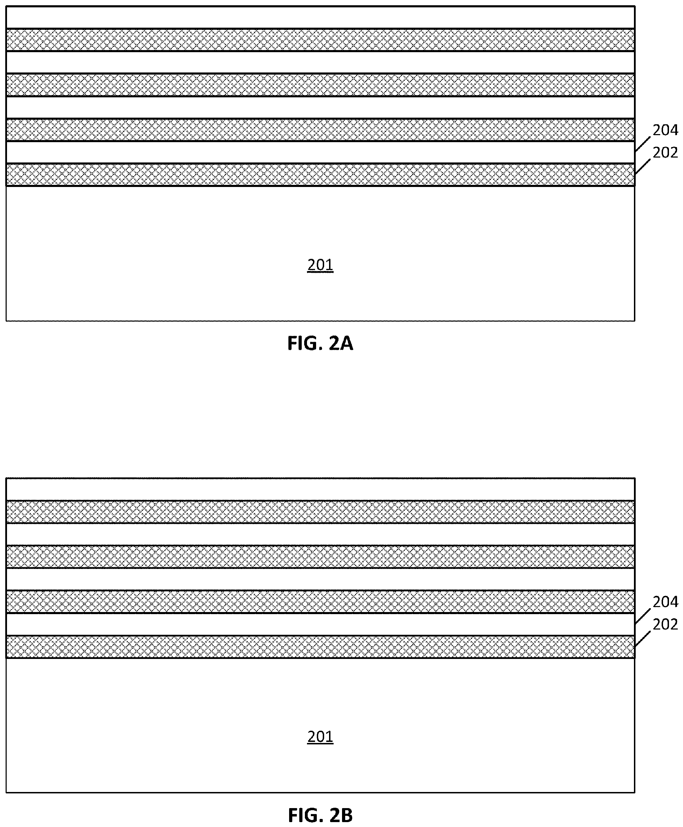

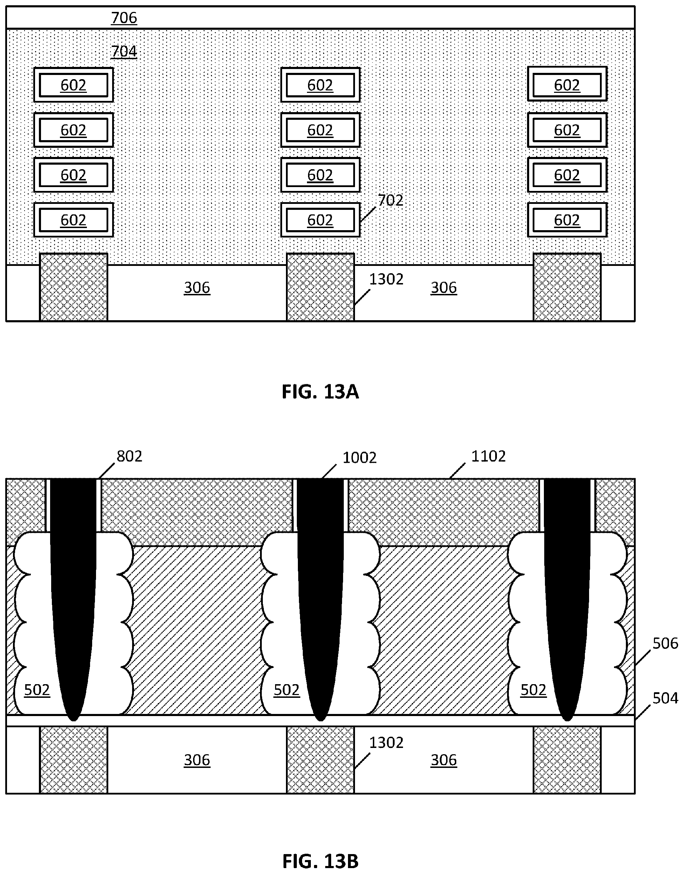

Figures 2A-13A and 2B-13B are cross-sectional views that collectively illustrate an example process for forming an integrated circuit that includes various thermal management structures, in accordance with an embodiment of the present disclosure. Figures 2A-13A represent cross-sectional views taken across a gate trench of the integrated circuit, while figures 2B-13B represent cross-sectional views taken across the source/drain trench adjacent to the gate trench along the same direction. Each figure shows an example structure that results from the process flow up to that point in time, so the depicted structure evolves as the process flow continues, culminating in the structure shown in Figures 13A and 13B, which is similar to the structure shown in Figures 1A and 1B, respectively. Such a structure may be part of an overall integrated circuit (e.g., such as a processor or memory chip) that includes, for example, digital logic cells and/or memory cells and analog mixed signal circuitry. Thus, the illustrated integrated circuit structure may be part of a larger integrated circuit that includes other integrated circuitry not depicted. Example materials and process parameters are given, but the present disclosure is not intended to be limited to any specific such materials or parameters, as will be appreciated. Figures sharing the same number (e.g., Figures 2A and 2B) illustrate different views of the structure at the same point in time during the process flow.

Figures 2A and 2B illustrate parallel cross-sectional views taken through a stack of alternating semiconductor layers on semiconductor substrate 201. Figure 2A is taken across a portion of the stack that will eventually become a gate trench while Figure 2B is taken across a portion of the stack that will eventually become a source/drain trench adjacent and parallel to the gate trench. Alternating material layers may be deposited over substrate 201 including sacrificial layers 202 alternating with semiconductor layers 204. The alternating layers are used to form GAA transistor structures. Any number of alternating semiconductor layers 204 and sacrificial layers 202 may be deposited over substrate 201.

Substrate 201 can be, for example, a bulk substrate including group IV semiconductor material (such as silicon, germanium, or silicon germanium), group III-V semiconductor material (such as gallium arsenide, indium gallium arsenide, or indium phosphide), and/or any other suitable material upon which transistors can be formed. Alternatively, substrate 201 can be a semiconductor-on-insulator substrate having a desired semiconductor layer over a buried insulator layer (e.g., silicon over silicon dioxide). Alternatively, substrate 201 can be a multilayer substrate or superlattice suitable for forming nanowires or nanoribbons (e.g., alternating layers of silicon and SiGe, or alternating layers indium gallium arsenide and indium phosphide). Any number of substrates can be used.

According to some embodiments, sacrificial layers 202 have a different material composition than semiconductor layers 204. In some embodiments, sacrificial layers 202 are silicon germanium (SiGe) while semiconductor layers 204 include a semiconductor material suitable for use as a nanoribbon such as silicon (Si), SiGe, germanium, or III-V materials like indium phosphide (InP) or gallium arsenide (GaAs). In examples where SiGe is used in each of sacrificial layers 202 and in semiconductor layers 204, the germanium concentration is different between sacrificial layers 202 and semiconductor layers 204. For example, sacrificial layers 202 may include a higher germanium content compared to semiconductor layers 204.

While dimensions can vary from one example embodiment to the next, the thickness of each sacrificial layer 202 in some examples may be between about 5 nm and about 20 nm. In some embodiments, the thickness of each sacrificial layer 202 is substantially the same (e.g., within 1-2 nm), and the thickness of each of semiconductor layers 204 may be about the same as the thickness of each sacrificial layer 202 (e.g., about 5-20 nm). Each of sacrificial layers 202 and semiconductor layers 204 may be deposited using any known or proprietary material deposition technique, such as chemical vapor deposition (CVD), plasma-enhanced chemical vapor deposition (PECVD), physical vapor deposition (PVD), or atomic layer deposition (ALD).

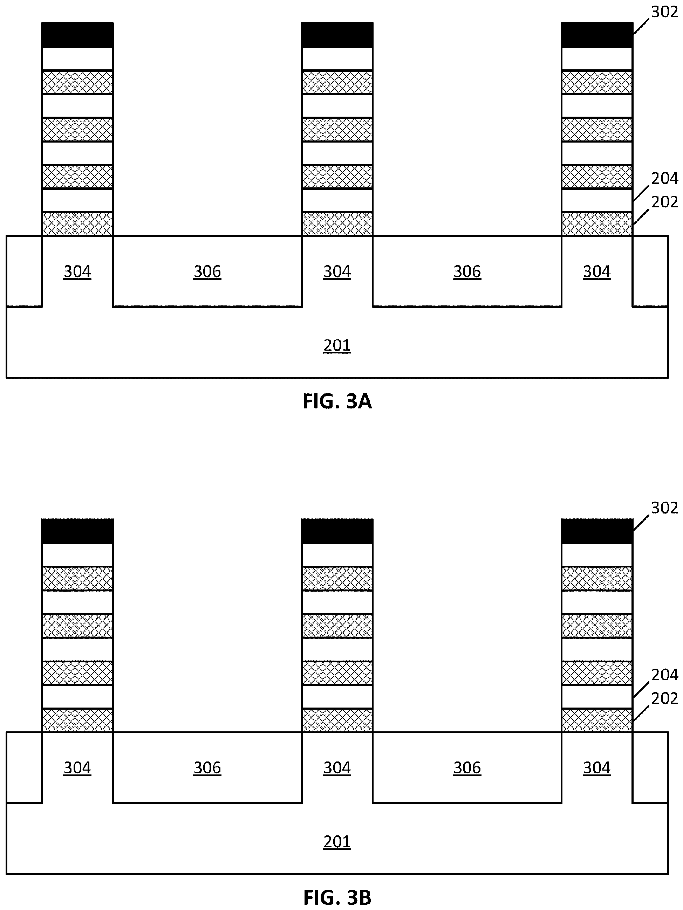

Figures 3A and 3B depict the cross-section views of the structure shown in Figures 2A and 2B, respectively, following the formation of a cap layer 302 and the subsequent formation of fins beneath cap layer 302, according to an embodiment. Cap layer 302 may be any suitable hard mask material such as a carbon hard mask (CHM) or silicon nitride. Cap layer 302 is patterned into rows to form corresponding rows of fins from the alternating layer stack of sacrificial layers 202 and semiconductor layers 204. The rows of fins extend lengthwise in a first direction (e.g., into and out of the page of each cross-section view).

According to some embodiments, an anisotropic etching process through the layer stack continues into at least a portion of substrate 201, where the unetched portions of substrate 201 beneath the fins form subfin regions 304. The etched portions of substrate 201 may be filled with a dielectric fill 306 that acts as shallow trench isolation (STI) between adjacent fins. Dielectric fill 306 may be any suitable dielectric material such as silicon dioxide, and may be recessed to a desired depth as shown (in this example case, down to around the upper surface of subfin regions 304), so as to define the active portion of the fins that will be covered by a gate structure. In some embodiments, dielectric fill 306 is recessed below the top surface of subfin regions 304.

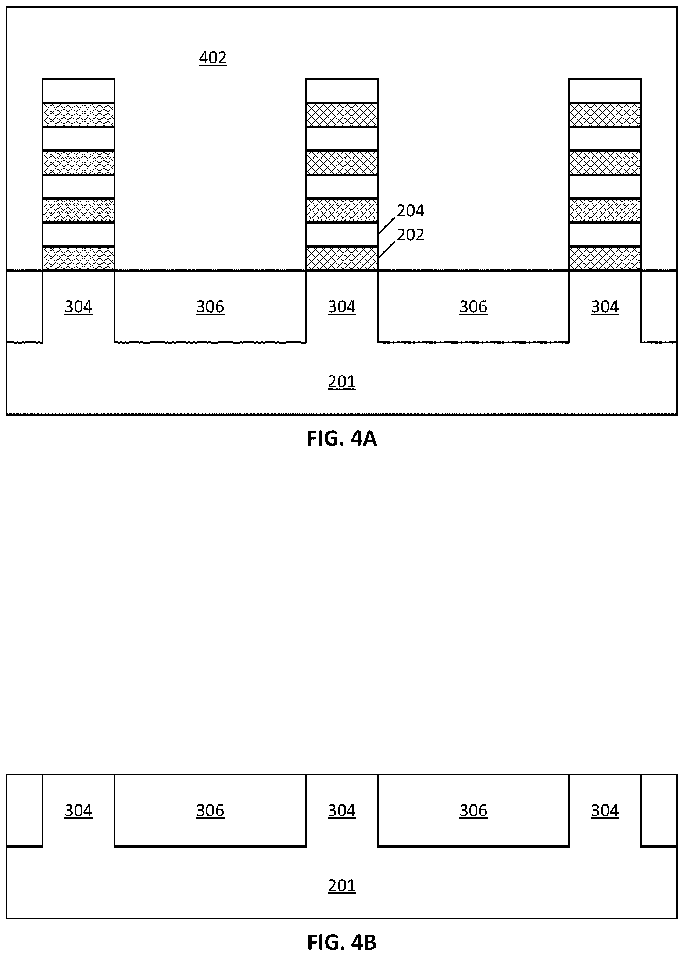

Figures 4A and 4B depict the cross-section views of the structure shown in Figures 3A and 3B, respectively, following the formation of a sacrificial gate 402 extending across the fins in a second direction different from the first direction, according to some embodiments. Sacrificial gate 402 may extend across the fins in a second direction that is orthogonal to the first direction. According to some embodiments, the sacrificial gate material is formed in parallel strips across the integrated circuit and removed in all areas not protected by a gate masking layer. Sacrificial gate 402 may be any suitable material that can be selectively removed without damaging the semiconductor material of the fins. In some examples, sacrificial gate 402 includes polysilicon.

As seen in the cross-section views, sacrificial gate 402 extends across the fins along the gate trench cross-section of Figure 4A but is not present along the source/drain trench cross-section of Figure 4B. Accordingly, sacrificial gate 402 (along with any gate spacers formed on the sidewalls of sacrificial gate 402) protect the underlying portions of the fins while the exposed portions of the fins are etched away as seen in Figure 4B. According to some embodiments, both semiconductor layers 204 and sacrificial layers 202 are etched at substantially the same rate using an anisotropic reactive ion etching (RIE) process. As observed in Figure 4B, the fins are completely removed above subfin regions 304. In some embodiments, the RIE process may also etch into subfin regions 304 thus recessing subfin regions 304 beneath a top surface of dielectric fill 306. In some embodiments, inner gate spacers can be formed after the source/drain trenches are etched and before any formation of source or drain regions. For instance, a selective etch can be used to laterally recess sacrificial layers 202, and that recess can then be filled with inner gate spacer material (e.g., silicon nitride or silicon oxynitride). Any excess gate spacer material can be removed with any suitable etching process.

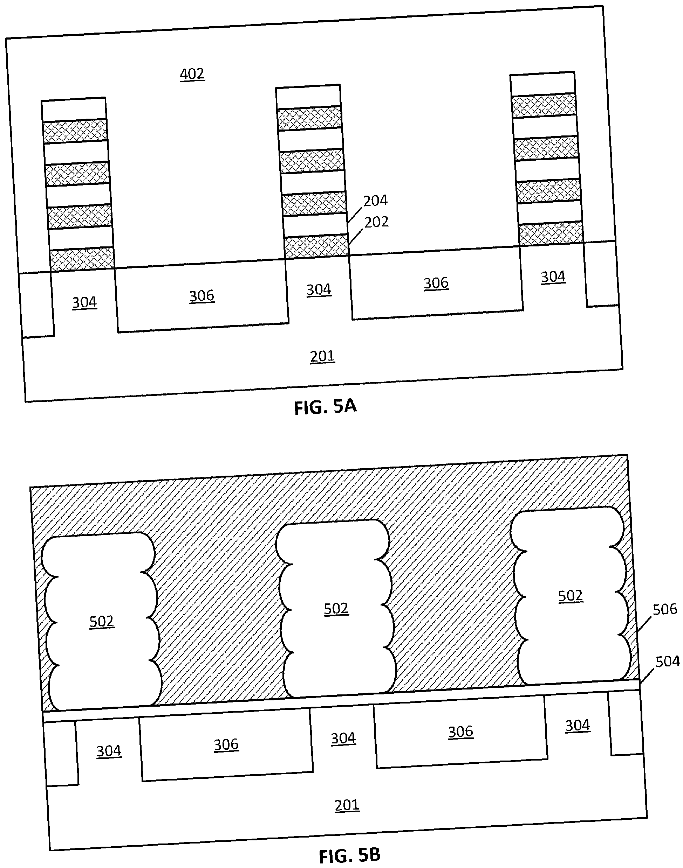

Figures 5A and 5B depict the cross-section views of the structure shown in Figures 4A and 4B, respectively, following the formation of source or drain regions 502 at the ends of each of the fins (extending into and out of the page in Figure 5A), according to some embodiments. Source or drain regions 502 may be epitaxially grown from the exposed ends of semiconductor layers 204, such that the material grows together or otherwise merges towards the middle of the trenches between fins, according to some embodiments. Note that epitaxial growth on one semiconductor layer 204 can fully or partially merge with epitaxial growth on one or more other semiconductor layers 204 in the same vertical stack. The degree of any such merging can vary from one embodiment to the next. In the example of a PMOS device, a given source or drain region may be a semiconductor material (e.g., group IV or group III-V semiconductor materials) having a higher dopant concentration of p-type dopants compared to n-type dopants. In the example of an NMOS device, a given source or drain region may be a semiconductor material (e.g., group IV or group III-V semiconductor materials) having a higher dopant concentration of n-type dopants compared to p-type dopants. According to some embodiments, source or drain regions 502 grown from different semiconductor devices may be aligned along the source/drain trench in the second direction as shown in Figure 5B.

According to some embodiments, a bottom dielectric layer 504 may be deposited prior to the formation of source or drain regions 502. Bottom dielectric layer 504 may be any suitable dielectric material, such as silicon dioxide, silicon nitride, or silicon oxynitride. In some example, bottom dielectric layer 504 includes excess dielectric material that remains after the formation of the inner gate spacers as discussed above with reference to Figures 4A and 4B.

According to some embodiments, another dielectric fill 506 is provided within the source/drain trench. Dielectric fill 506 may extend between adjacent ones of the source or drain regions 502 along the second direction and also may extend up and over each of the source or drain regions 502, according to some embodiments. Accordingly, each source or drain region may be isolated from any adjacent source or drain regions by dielectric fill 506. Dielectric fill 506 may be any suitable dielectric material, although in some embodiments, dielectric fill 506 includes the same dielectric material as dielectric fill 306. In one example, both dielectric fill 506 and dielectric fill 306 include silicon dioxide. According to some embodiments, a top surface of dielectric fill 506 may be polished using, for example, CMP. The top surface of dielectric fill 506 may be polished until it is substantially coplanar with a top surface of sacrificial gate 402.

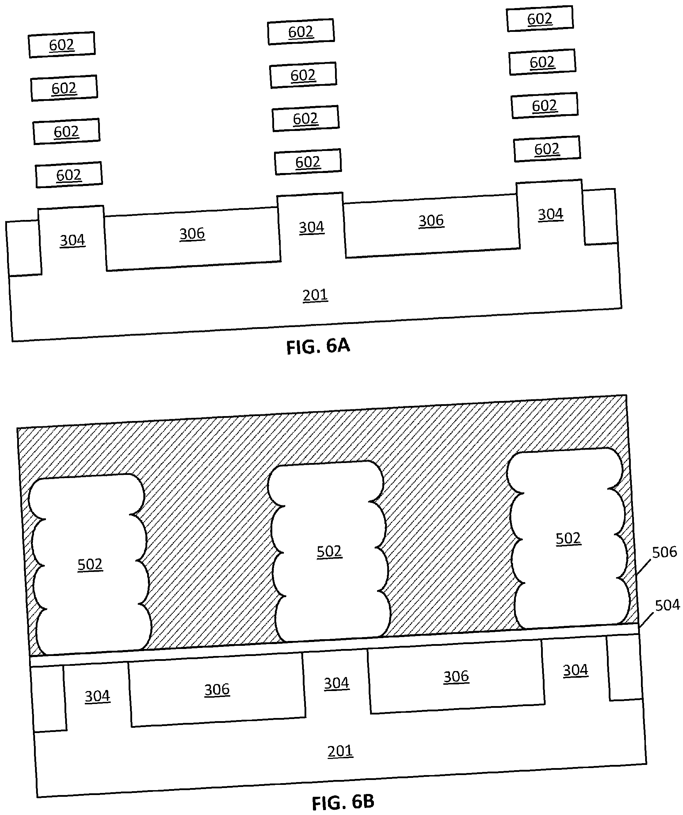

Figures 6A and 6B depict the cross-section views of the structure shown in Figures 5A and 5B, respectively, following the formation of nanoribbons 602 from semiconductor layers 204, according to some embodiments. Depending on the dimensions of the structures, nanoribbons 602 may also be considered nanowires or nanosheets. Sacrificial gate 402 may be removed using any wet or dry isotropic process thus exposing the alternating layer stack of the fins within the trenches left behind after the removal of sacrificial gate 402. Once sacrificial gate 402 is removed, sacrificial layers 202 may also be removed using a selective isotropic etching process that removes the material of sacrificial layers 202 but does not remove (or removes very little of) semiconductor layers 204 or any other exposed layers (e.g., inner gate spacers). At this point, the suspended (sometimes called released) semiconductor layers 204 form nanoribbons 602 that extend in the first direction (into and out of the page) between corresponding source or drain regions 502.

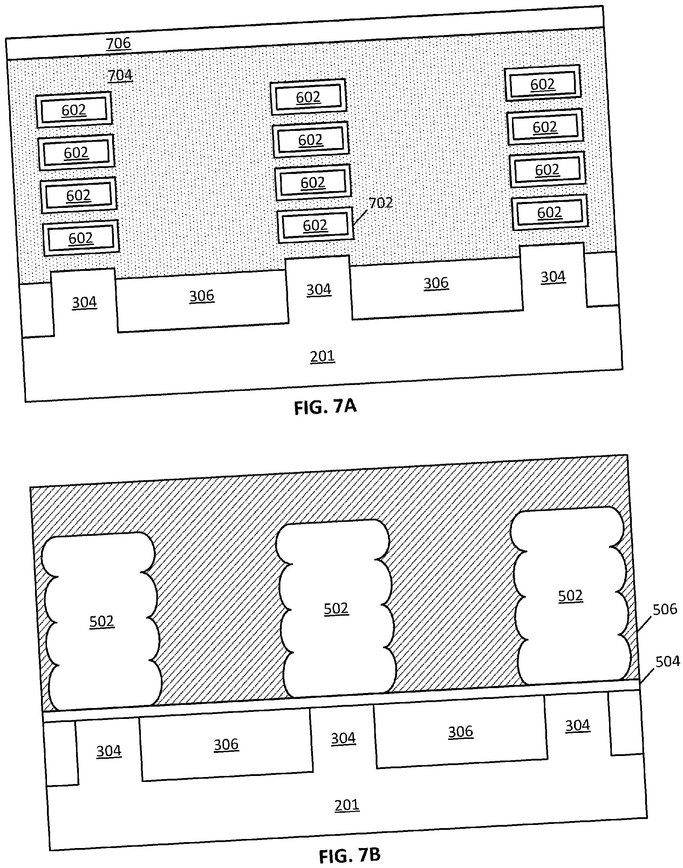

Figures 7A and 7B depict the cross-section views of the structure shown in Figures 6A and 6B, respectively, following the formation of a gate structure around nanoribbons 602 within the gate trench, according to some embodiments. As noted above, the gate structure includes a gate dielectric 702 and a gate electrode 704. Gate dielectric 702 may be conformally deposited around nanoribbons 602 using any suitable deposition process, such as atomic layer deposition (ALD). Gate dielectric 702 may include any suitable dielectric (such as silicon dioxide, and/or a high-k dielectric material). Examples of high-k dielectric materials include, for instance, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate, to provide some examples. According to some embodiments, gate dielectric 702 is hafnium oxide with a thickness between about 1 nm and about 5 nm. In some embodiments, gate dielectric 702 may include one or more silicates (e.g., titanium silicate, tungsten silicate, niobium silicate, and silicates of other transition metals). Gate dielectric 702 may be a multilayer structure, in some examples. For instance, gate dielectric 702 may include a first layer on nanoribbons 602, and a second layer on the first layer. The first layer can be, for instance, an oxide of the semiconductor layers (e.g., silicon dioxide) and the second layer can be a high-k dielectric material (e.g., hafnium oxide). In some embodiments, an annealing process may be carried out on gate dielectric 702 to improve its quality when a high-k dielectric material is used.

Gate electrode 704 may be deposited over gate dielectric 702 and can be any conductive structure. In some embodiments, gate electrode 704 includes doped polysilicon, a metal, or a metal alloy. Example suitable metals or metal alloys include aluminum, tungsten, cobalt, molybdenum, ruthenium, titanium, tantalum, copper, and carbides and nitrides thereof. Gate electrode 704 may include, for instance, one or more workfunction layers, resistance-reducing layers, and/or barrier layers. The workfunction layers can include, for example, p-type workfunction materials (e.g., titanium nitride) for PMOS gates, or n-type workfunction materials (e.g., titanium aluminum carbide) for NMOS gates.

According to some embodiments, a gate cap 706 may be formed by first recessing gate electrode 704 and filling the recess with a dielectric material. The dielectric material may then be polished such that its top surface is substantially coplanar with any adjacent spacer structures or material within the source/drain trench (e.g., dielectric fill 506). Gate cap 706 may be any suitable dielectric material, such as silicon nitride.

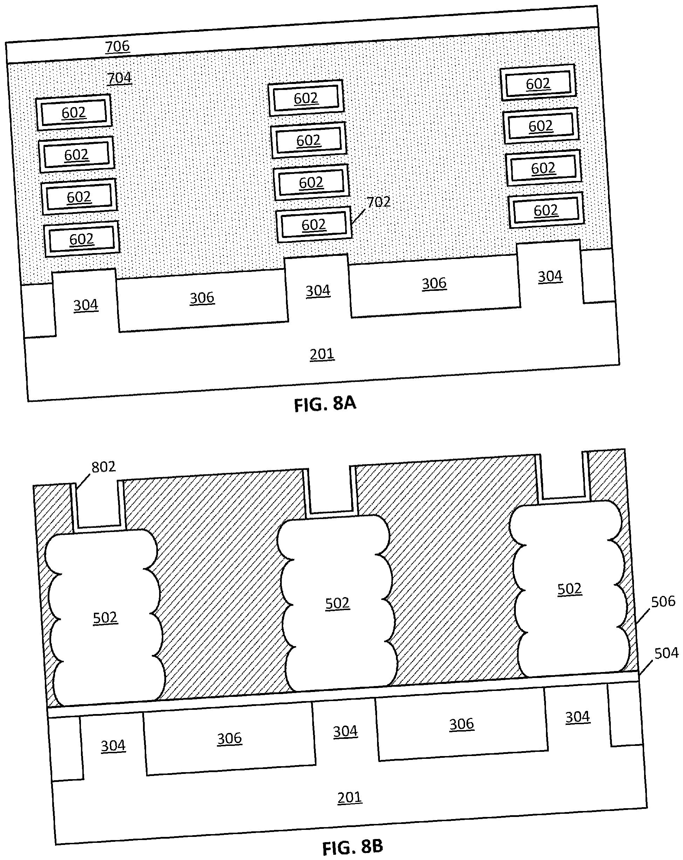

Figures 8A and 8B depict cross-section views of the structure shown in Figures 7A and 7B, respectively, following the formation of contact recesses formed within the source/drain trench, according to some embodiments. Suitable lithography operations may be performed along with a directional etching process (e.g., RIE) to form recesses through dielectric fill 506 that expose at least a portion of a top surface of any number of source or drain regions 502. According to some embodiments, a dielectric liner 802 may be formed within the recesses. Dielectric liner 802 may be formed conformally on all exposed surfaces within the recesses. Dielectric liner 802 may include any suitable dielectric material, such as silicon nitride or silicon oxynitride and may have a thickness, for example, between 1 nm to 3 nm. In some examples, dielectric liner 802 is omitted.

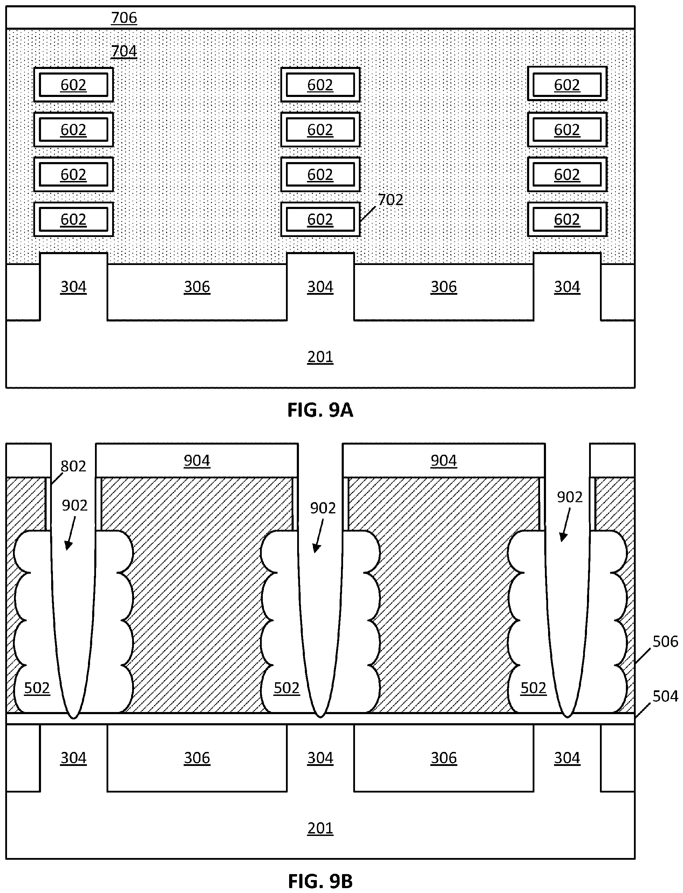

Figures 9A and 9B depict cross-section views of the structure shown in Figures 8A and 8B, respectively, following another etching process to form recesses 902 extending into source or drain regions 502, according to some embodiments. A masking layer 904 may first be formed over the top surface of dielectric fill 506, while little to none of masking layer 904 is formed within the recesses. In some embodiments, masking layer 904 is deposited using physical vapor deposition (PVD), such as sputtering, to preferentially deposit the material on the planar top surface of dielectric fill 506. Masking layer 904 may include any suitable dielectric hard mask material or a carbon hard mask (CHM).

Following the formation of masking layer 904, a directional RIE process may be performed to punch through a portion of dielectric liner 802 on the top surface of source or drain regions 502. The etching process may then continue into source or drain regions 502 to form recesses 902. In some examples, recesses 902 extend through at least 25%, at least 50%, or at least 75% of an entire height (e.g., along the Z direction) of source or drain regions 502. In some examples, recesses 902 extend through the entire height of source or drain regions 502, as illustrated in Figure 9B. Note that a small portion of dielectric liner 802 may remain on the top surface of source or drain regions 502 around the opening to recesses 902. Recesses 902 may also exhibit a tapering width, forming an elongated oval shape with a dome-shaped, pointed, or flat end.

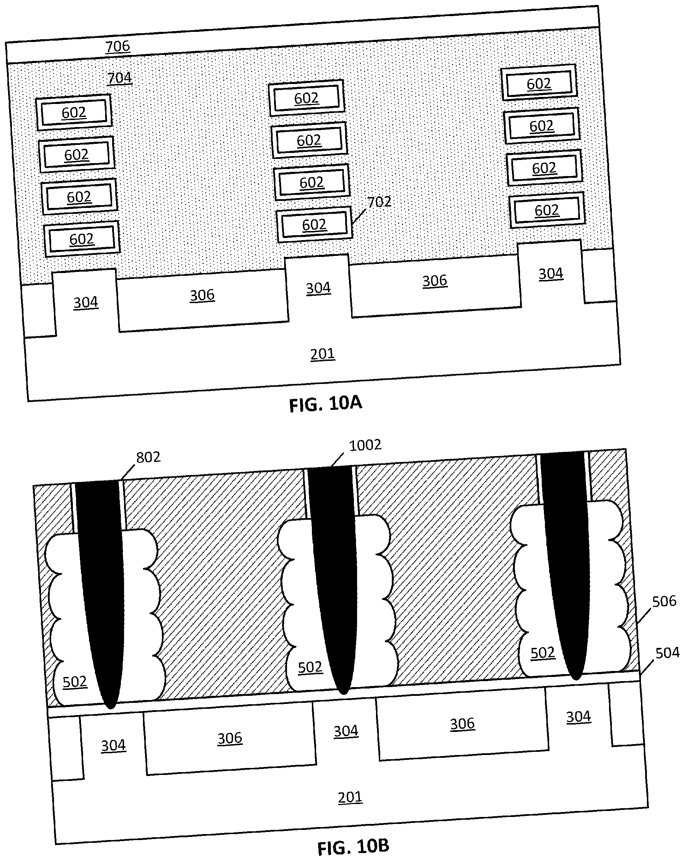

Figures 10A and 10B depict cross-section views of the structure shown in Figures 9A and 9B, respectively, following the formation of conductive contacts 1002 within recesses 902 extending through source or drain regions 502, according to some embodiments. Conductive contacts 1002 may include any suitable conductive material, such as tungsten, molybdenum, ruthenium, or cobalt. A top surface of conductive contacts 1002 may be polished to be substantially coplanar with a top surface of gate cap 706 (or a top surface of dielectric fill 506). Conductive contacts 1002 will take the respective shape of recesses 902 and accordingly may have a generally tapered profile as they extend through source or drain regions 502. According to some embodiments, the portion of conductive contacts 1002 that extends through source or drain regions 502 has an elongated oval shape with a domed, pointed, or flat end.

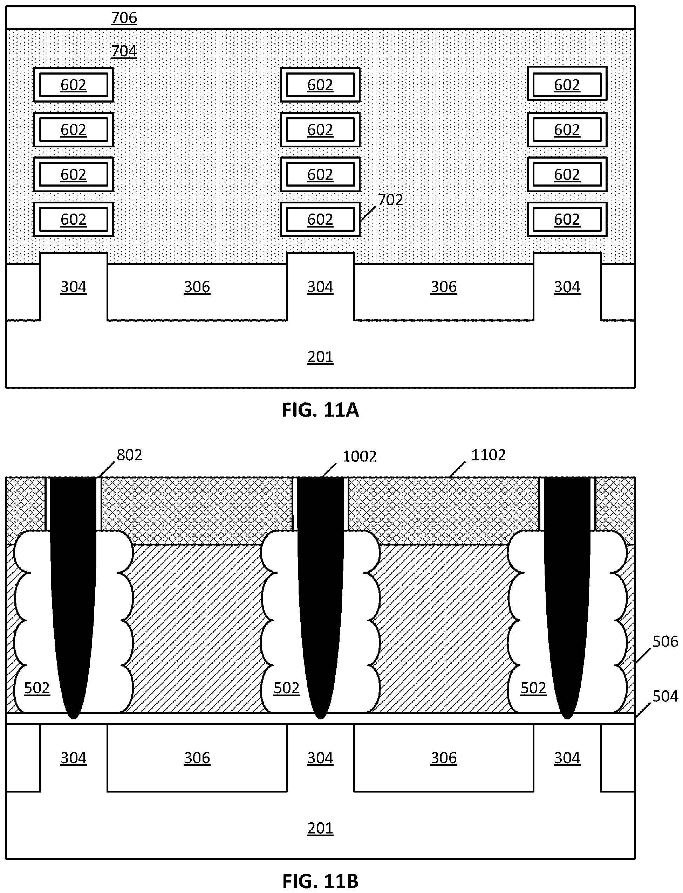

Figures 11A and 11B depict cross-section views of the structure shown in Figures 10A and 10B, respectively, following the recessing of dielectric fill 506 and replacing the removed portion of dielectric fill 506 with a first material layer 1102, according to some embodiments. First material layer 1102 may be any material having a thermal conductivity of at least 1.5 W/m·K, at least 10 W/m·K, or at least 20 W/m·K, according to some embodiments. Example materials for first material layer 1102 include silicon carbide, diamond, aluminum nitride, boron nitride, silicon nitride, or aluminum oxide. According to some embodiments, first material layer 1102 substantially fills the top region of the source/drain trench along the second direction between adjacent contacts 1002. In some examples, first material layer 1102 extends below the top surfaces of source or drain regions 502. In some examples, the bottom surface of first material layer 1102 is substantially coplanar with the top surfaces of source or drain regions 502. In some examples, the bottom surface of first material layer 1102 is above the top surfaces of source or drain regions 502. As shown in Figure 11B, first material layer 1102 directly abuts dielectric liner 802 on the sidewalls of conductive contacts 1002. However, in some embodiments, dielectric liner 802 is not present in which case first material layer 1102 directly abuts adjacent conductive contacts 1002 as it extends along the second direction within the source/drain trench. A top surface of first material layer 1102 may be polished to be substantially coplanar with a top surface of contacts 1002.

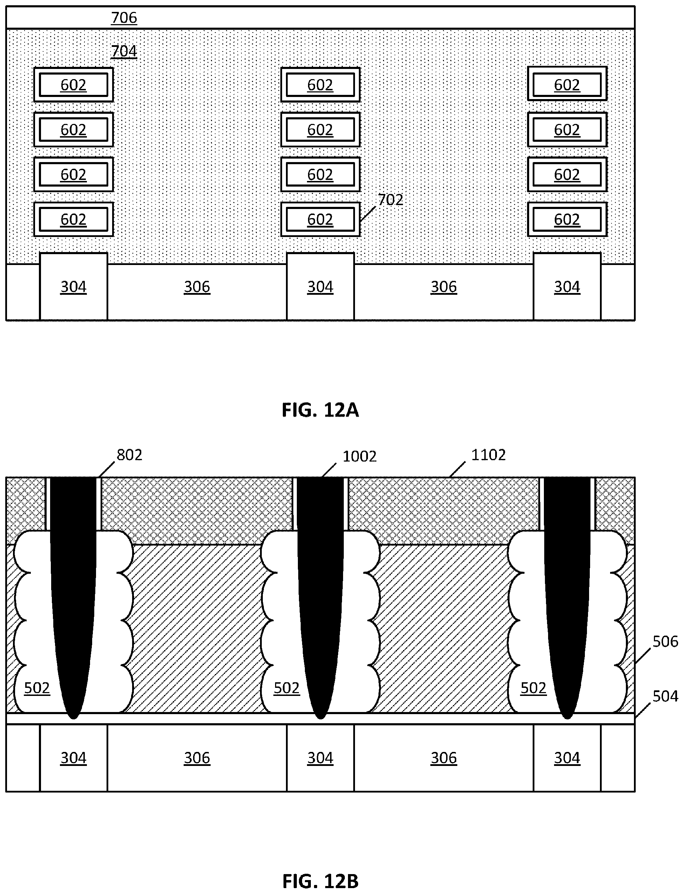

Figures 12A and 12B depict cross-section views of the structure shown in Figures 11A and 11B, respectively, following the removal of substrate 201 from the backside, which exposes a bottom surface of subfin regions 304 and a bottom surface of dielectric fill 306, according to some embodiments. Once all front-side processes have been performed across the integrated circuit (including the formation of any front-side interconnect structures), substrate 201 may be removed via any arrangement of grinding, polishing, and/or chemical etching processes. According to some embodiments, all materials are removed from the backside up until at least a bottom surface of dielectric fill 306 is exposed.

Figures 13A and 13B depict cross-section views of the structure shown in Figures 12A and 12B, respectively, following the replacement of subfin regions 304 with a second material layer 1302, according to some embodiments. Subfin regions 304 may be removed using any suitable isotropic etching process to selectively remove the semiconductor material of subfin regions 304. The resulting backside recesses may then be filled with second material layer 1302 to form subregions beneath nanoribbons 602 (and beneath source or drain regions 502). According to some embodiments, second material layer 1302 may be any material having a thermal conductivity of at least 1.5 W/m·K, at least 20 W/m·K, or at least 300 W/m·K. Example materials for second material layer 1302 include silicon carbide, diamond, aluminum nitride, or boron nitride. In some embodiments, second material layer 1302 may be any material having a thermal conductivity of at least 1.5 W/m·K, which can include silicon nitride or aluminum oxide. A bottom surface of second material layer 1302 may be polished to be substantially coplanar with a bottom surface of dielectric fill 306. In some embodiments, the bottom surface of material layer 1302 is below a bottom surface of dielectric fill 306, such that a portion of material layer 1302 is also on the bottom surface of dielectric fill 306.

It should be understood that the various types of thermal management structures described herein need not all be present at the same time for a given device or set of devices. Thus, in some examples, devices may include first material layer 1102, but not second material layer 1302 and/or not have deep contacts 1002. Similarly, devices may include second material layer 1302, but not first material layer 1102 and/or not have deep contacts 1002.

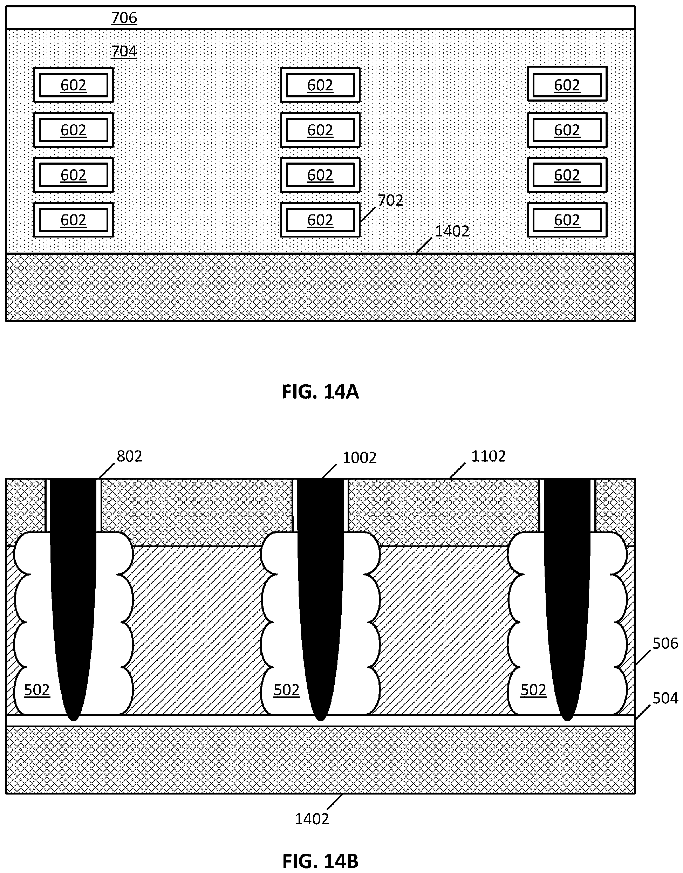

The subregion beneath nanoribbons 602 and source or drain regions 502 may have a different structure than what is illustrated in Figures 13A and 13B. For example, Figures 14A and 14B illustrate a portion of an integrated circuit where dielectric fill 306 is also removed from the backside such that a material layer 1402 extends along the second direction beneath multiple devices. According to some embodiments, dielectric fill 306 is removed from the backside using a suitable isotropic etching process around the same time that subfin regions 304 are removed from the backside. Material layer 1402 may be any material having a thermal conductivity of at least 1.5 W/m·K, at least 20 W/m·K, or at least 300 W/m·K. Example materials for material layer 1402 include silicon carbide, diamond, aluminum nitride, or boron nitride.

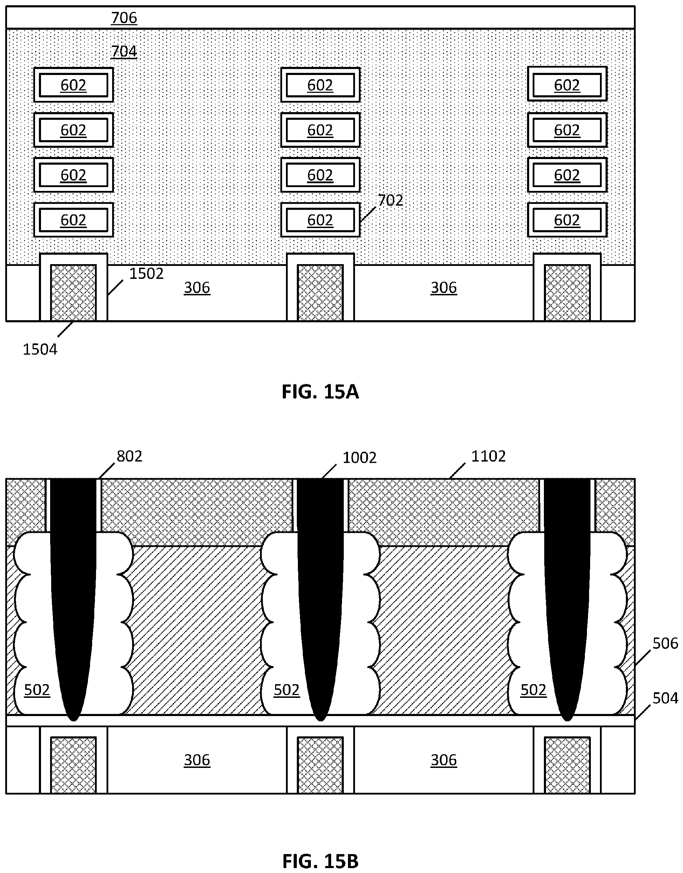

In some embodiments, the subregions beneath nanoribbons 602 and source or drain regions 502 include more than one deposited material to form the thermally conductive structures. Figures 15A and 15B illustrate examples where the subregions include a material liner 1502 on a material fill 1504. According to some embodiments, each of material liner 1502 and material fill 1504 include materials having a thermal conductivity of at least 1.5 W/m·K, at least 20 W/m·K, or at least 300 W/m·K. In an example, material liner 1502 is boron nitride. Material liner 1502 may have a thickness, for example, between about 2 nm and about 6 nm. In some examples, material liner 1502 also extends beyond the recesses, such as on a bottom surface of dielectric fill 306.

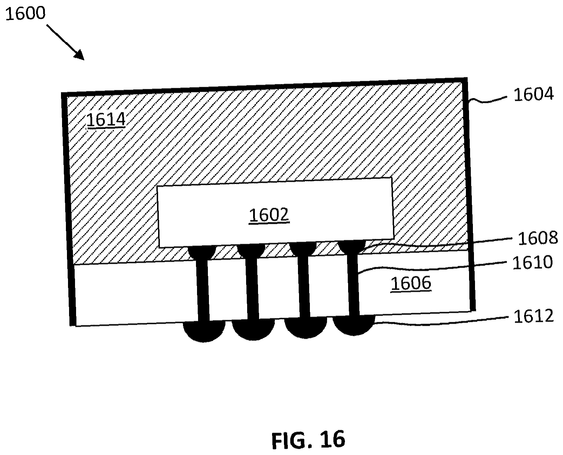

Figure 16 illustrates an example embodiment of a chip package 1600, in accordance with an embodiment of the present disclosure. As can be seen, chip package 1600 includes one or more dies 1602. One or more dies 1602 may include at least one integrated circuit having semiconductor devices, such as any of the semiconductor devices disclosed herein. One or more dies 1602 may include any other circuitry used to interface with other devices formed on the dies, or other devices connected to chip package 1600, in some example configurations.

As can be further seen, chip package 1600 includes a housing 1604 that is bonded to a package substrate 1606. The housing 1604 may be any standard or proprietary housing, and may provide, for example, electromagnetic shielding and environmental protection for the components of chip package 1600. The one or more dies 1602 may be conductively coupled to a package substrate 1606 using connections 1608, which may be implemented with any number of standard or proprietary connection mechanisms, such as solder bumps, ball grid array (BGA), pins, or wire bonds, to name a few examples. Package substrate 1606 may be any standard or proprietary package substrate, but in some cases includes a dielectric material having conductive pathways (e.g., including conductive vias and lines) extending through the dielectric material between the faces of package substrate 1606, or between different locations on each face. In some embodiments, package substrate 1606 may have a thickness less than 1 millimeter (e.g., between 0.1 millimeters and 0.5 millimeters), although any number of package geometries can be used. Additional conductive contacts 1612 may be disposed at an opposite face of package substrate 1606 for conductively contacting, for instance, a printed circuit board (PCB). One or more vias 1610 extend through a thickness of package substrate 1606 to provide conductive pathways between one or more of connections 1608 to one or more of contacts 1612. Vias 1610 are illustrated as single straight columns through package substrate 1606 for ease of illustration, although other configurations can be used (e.g., damascene, dual damascene, through-silicon via, or an interconnect structure that meanders through the thickness of substrate 1606 to contact one or more intermediate locations therein). In still other embodiments, vias 1610 are fabricated by multiple smaller stacked vias, or are staggered at different locations across package substrate 1606. In the illustrated embodiment, contacts 1612 are solder balls (e.g., for bump-based connections or a ball grid array arrangement), but any suitable package bonding mechanism may be used (e.g., pins in a pin grid array arrangement or lands in a land grid array arrangement). In some embodiments, a solder resist is disposed between contacts 1612, to inhibit shorting.

In some embodiments, a mold material 1614 may be disposed around the one or more dies 1602 included within housing 1604 (e.g., between dies 1602 and package substrate 1606 as an underfill material, as well as between dies 1602 and housing 1604 as an overfill material). Although the dimensions and qualities of the mold material 1614 can vary from one embodiment to the next, in some embodiments, a thickness of mold material 1614 is less than 1 millimeter. Example materials that may be used for mold material 1614 include epoxy mold materials, as suitable. In some cases, the mold material 1614 is thermally conductive, in addition to being electrically insulating.

### Example System

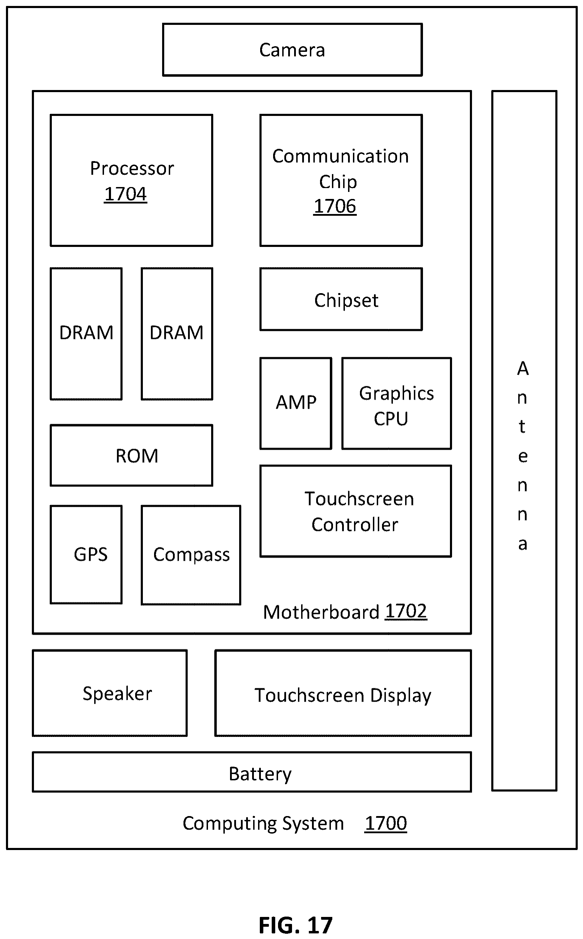

FIG. 17 is an example computing system implemented with one or more of the integrated circuit structures as disclosed herein, in accordance with some embodiments of the present disclosure. As can be seen, the computing system 1700 houses a motherboard 1702. The motherboard 1702 may include a number of components, including, but not limited to, a processor 1704 and at least one communication chip 1706, each of which can be physically and electrically coupled to the motherboard 1702, or otherwise integrated therein. As will be appreciated, the motherboard 1702 may be, for example, any printed circuit board (PCB), whether a main board, a daughterboard mounted on a main board, or the only board of system 1700, etc.

Depending on its applications, computing system 1700 may include one or more other components that may or may not be physically and electrically coupled to the motherboard 1702. These other components may include, but are not limited to, volatile memory (e.g., DRAM), non-volatile memory (e.g., ROM), a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth). Any of the components included in computing system 1700 may include one or more integrated circuit structures or devices configured in accordance with an example embodiment, such as a module including an integrated circuit on a substrate, the substrate having semiconductor devices with one or more various types of thermal management structures. In some embodiments, multiple functions can be integrated into one or more chips (e.g., for instance, note that the communication chip 1706 can be part of or otherwise integrated into the processor 1704).

The communication chip 1706 enables wireless communications for the transfer of data to and from the computing system 1700. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 1706 may implement any of a number of wireless standards or protocols, including, but not limited to, Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing system 1700 may include a plurality of communication chips 1706. For instance, a first communication chip 1706 may be dedicated to shorter range wireless communications such as Wi-Fi and Bluetooth and a second communication chip 1706 may be dedicated to longer range wireless communications such as GPS, EDGE, GPRS, CDMA, WiMAX, LTE, Ev-DO, and others.

The processor 1704 of the computing system 1700 includes an integrated circuit die packaged within the processor 1704. In some embodiments, the integrated circuit die of the processor includes onboard circuitry that is implemented with one or more semiconductor devices as variously described herein. The term "processor" may refer to any device or portion of a device that processes, for instance, electronic data from registers and/or memory to transform that electronic data into other electronic data that may be stored in registers and/or memory.

The communication chip 1706 also may include an integrated circuit die packaged within the communication chip 1706. In accordance with some such example embodiments, the integrated circuit die of the communication chip includes one or more semiconductor devices as variously described herein. As will be appreciated in light of this disclosure, note that multi-standard wireless capability may be integrated directly into the processor 1704 (e.g., where functionality of any chips 1706 is integrated into processor 1704, rather than having separate communication chips). Further note that processor 1704 may be a chip set having such wireless capability. In short, any number of processor 1704 and/or communication chips 1706 can be used. Likewise, any one chip or chip set can have multiple functions integrated therein.

In various implementations, the computing system 1700 may be a laptop, a netbook, a notebook, a smartphone, a tablet, a personal digital assistant (PDA), an ultra-mobile PC, a mobile phone, a desktop computer, a server, a printer, a scanner, a monitor, a set-top box, an entertainment control unit, a digital camera, a portable music player, a digital video recorder, or any other electronic device that processes data or employs one or more integrated circuit structures or devices formed using the disclosed techniques, as variously described herein.

It will be appreciated that in some embodiments, the various components of the computing system 1700 may be combined or integrated in a system-on-a-chip (SoC) architecture. In some embodiments, the components may be hardware components, firmware components, software components or any suitable combination of hardware, firmware or software.

### Further Example Embodiments

The following examples pertain to further embodiments, from which numerous permutations and configurations will be apparent.

Example 1 is an integrated circuit that includes a semiconductor region extending from a source or drain region in a first direction, a gate structure extending over the semiconductor region in a second direction different from the first direction, a dielectric layer beneath the gate structure, and a subregion beneath the semiconductor region. The subregion extends through at least a portion of a thickness of the dielectric layer. The subregion includes a material having a thermal conductivity of, for example, at least 1.5 W/m·K.

Example 2 includes the integrated circuit of Example 1, wherein the material substantially fills the subregion such that a bottom surface of the material is substantially coplanar with a bottom surface of the dielectric layer.

Example 3 includes the integrated circuit of Example 1, wherein the material substantially fills the subregion and extends below a bottom surface of the dielectric layer.

Example 4 includes the integrated circuit of any one of Examples 1-3, wherein the material is a liner material on outside surfaces of the subregion, and the subregion further comprises a fill material on the liner material.

Example 5 includes the integrated circuit of Example 4, wherein the liner material is also on a bottom surface of the dielectric layer.

Example 6 includes the integrated circuit of Example 4 or 5, wherein the liner material comprises boron and nitrogen.

Example 7 includes the integrated circuit of any one of Examples 4-6, wherein the liner material has a thickness between about 2 nm and about 6 nm.

Example 8 includes the integrated circuit of any one of Examples 1-7, wherein the material comprises aluminum and nitrogen.

Example 9 includes the integrated circuit of any one of Examples 1-7, wherein the material comprises silicon and carbon.

Example 10 includes the integrated circuit of any one of Examples 1-9, wherein the semiconductor region comprises one or more semiconductor nanoribbons.

Example 11 includes the integrated circuit of Example 10, wherein the one or more semiconductor nanoribbons comprises germanium, silicon, or any combination thereof.

Example 12 includes the integrated circuit of any one of Examples 1-11, wherein the semiconductor region is a first semiconductor region and the source or drain region is a first source or drain region. The integrated circuit further includes a second semiconductor region extending from a second source or drain region in the first direction with the second source or drain region being adjacent to the first source or drain region along the second direction, a first contact on a top surface of the first source or drain region, a second contact on a top surface of the second source or drain region, and a material layer between the first contact and the second contact having a thermal conductivity of at least 1.5 W/m·K.

Example 13 includes the integrated circuit of Example 12, wherein the material layer comprises silicon and nitrogen.

Example 14 includes the integrated circuit of Example 12, wherein the material layer comprises aluminum and nitrogen or comprises aluminum and oxygen.

Example 15 includes the integrated circuit of Example 12, wherein the material layer comprises silicon and carbon.

Example 16 includes the integrated circuit of any one of Examples 12-15, wherein a top surface of the material layer is substantially coplanar with a top surface of the first and second contacts.

Example 17 includes the integrated circuit of any one of Examples 1-16, further comprising a contact over a top surface of the source or drain region, wherein the contact extends through at least 50% of an entire height of the source or drain region.

Example 18 includes the integrated circuit of Example 17, wherein the contact extends through an entire height of the source or drain region.

Example 19 is a die that includes the integrated circuit of any one of Examples 1-18.

Example 20 is an integrated circuit that includes a first semiconductor region extending from a first source or drain region in a first direction, a second semiconductor region extending from a second source or drain region in the first direction, a gate structure extending over the first semiconductor region and/or the second semiconductor region in a second direction different from the first direction, a first contact on a top surface of the first source or drain region, a second contact on a top surface of the second source or drain region, and a material layer between the first contact and the second contact. The second source or drain region is adjacent to the first source or drain region along the second direction. The material layer has a thermal conductivity of, for example, at least 1./5 W/m·K.

Example 21 includes the integrated circuit of Example 20, wherein the material layer comprises silicon and nitrogen.

Example 22 includes the integrated circuit of Example 20, wherein the material layer comprises aluminum and nitrogen or comprises aluminum and oxygen.

Example 23 includes the integrated circuit of Example 20, wherein the material layer comprises silicon and carbon.

Example 24 includes the integrated circuit of any one of Examples 20-23, wherein a top surface of the material layer is substantially coplanar with a top surface of the first and second contacts.

Example 25 includes the integrated circuit of any one of Examples 20-24, further comprising: a dielectric layer beneath the gate structure; and a subregion beneath the first semiconductor region. The subregion extends through at least a portion of a thickness of the dielectric layer, and the subregion comprises a material having a thermal conductivity of at least 1.5 W/m·K.

Example 26 includes the integrated circuit of Example 25, wherein the material substantially fills the subregion such that a bottom surface of the material is substantially coplanar with a bottom surface of the dielectric layer.

Example 27 includes the integrated circuit of Example 25, wherein the material substantially fills the subregion and extends below a bottom surface of the dielectric layer.

Example 28 includes the integrated circuit of Example 25, wherein the material is a liner material on surfaces of the subregion, and the subregion further comprises a fill material on the liner material.

Example 29 includes the integrated circuit of Example 28, wherein the liner material is also on a bottom surface of the dielectric layer.

Example 30 includes the integrated circuit of Example 28 or 29, wherein the liner material comprises boron and nitrogen.

Example 31 includes the integrated circuit of any one of Examples 28-30, wherein the liner material has a thickness between about 2 nm and about 6 nm.

Example 32 includes the integrated circuit of any one of Examples 25-31, wherein the material comprises aluminum and nitrogen.

Example 33 includes the integrated circuit of any one of Examples 25-31, wherein the material comprises silicon and carbon.

Example 34 includes the integrated circuit of any one of Examples 20-33, wherein the first contact extends through at least 50% of an entire height of the first source or drain region.

Example 35 includes the integrated circuit of Example 34, wherein the first contact extends through an entire height of the first source or drain region.

Example 36 is a die that includes the integrated circuit of any one of Examples 20-35.

Example 37 is an integrated circuit that includes a first semiconductor region extending from a first source or drain region in a first direction, a second semiconductor region extending from a second source or drain region in the first direction, a gate structure extending over the first semiconductor region and/or the second semiconductor region in a second direction different from the first direction, a dielectric layer beneath the gate structure, a first contact over a top surface of the first source or drain region, a second contact over a top surface of the second source or drain region, a material layer between the first contact and the second contact along the second direction, and a subregion beneath the first semiconductor region or the second semiconductor region. The second source or drain region is adjacent to the first source or drain region along the second direction. In an example, the first contact extends through at least 50% of an entire height of the first source or drain region and/or the second contact extends through at least 50% of an entire height of the second source or drain region. The material layer has a thermal conductivity of, for example, at least 1.5 W/m·K. The subregion extends through at least a portion of a thickness of the dielectric layer and includes a material having a thermal conductivity of, for example, at least 1.5 W/m·K.

Example 38 includes the integrated circuit of Example 37, wherein the material substantially fills the subregion such that a bottom surface of the material is substantially coplanar with a bottom surface of the dielectric layer.

Example 39 includes the integrated circuit of Example 37, wherein the material substantially fills the subregion and extends below a bottom surface of the dielectric layer.

Example 40 includes the integrated circuit of Example 37, wherein the material is a liner material on surfaces of the subregion, and the subregion further comprises a fill material on the liner material.

Example 41 includes the integrated circuit of Example 40, wherein the liner material is also on a bottom surface of the dielectric layer.

Example 42 includes the integrated circuit of Example 40 or 41, wherein the liner material comprises boron and nitrogen.

Example 43 includes the integrated circuit of any one of Examples 40-42, wherein the liner material has a thickness between about 2 nm and about 6 nm.

Example 44 includes the integrated circuit of any one of Examples 37-43, wherein the material comprises aluminum and nitrogen.

Example 45 includes the integrated circuit of any one of Examples 37-43, wherein the material comprises silicon and carbon.

Example 46 includes the integrated circuit of any one of Examples 37-45, wherein the semiconductor region comprises one or more semiconductor nanoribbons.

Example 47 includes the integrated circuit of Example 46, wherein the one or more semiconductor nanoribbons comprises germanium, silicon, or any combination thereof.

Example 48 includes the integrated circuit of any one of Examples 37-47, wherein the material layer comprises silicon and nitrogen.

Example 49 includes the integrated circuit of any one of Examples 37-47, wherein the material layer comprises aluminum and nitrogen or comprises aluminum and oxygen.

Example 50 includes the integrated circuit of any one of Examples 37-47, wherein the material layer comprises silicon and carbon.

Example 51 includes the integrated circuit of any one of Examples 37-50, wherein a top surface of the material layer is substantially coplanar with a top surface of the first and second contacts.

Example 52 includes the integrated circuit of any one of Examples 37-51, wherein the first contact extends through an entire height of the first source or drain region and/or the second contact extends through an entire height of the second source or drain region.

Example 53 is a die that includes the integrated circuit of any one of Examples 37-52.

The foregoing description of the embodiments of the disclosure has been presented for the purposes of illustration and description. It is not intended to be exhaustive or to limit the disclosure to the precise forms disclosed. Many modifications and variations are possible in light of this disclosure. It is intended that the scope of the disclosure be limited not by this detailed description, but rather by the claims appended hereto.

## Claims

1. An integrated circuit comprising:
a semiconductor region extending from a source or drain region in a first direction;
a gate structure extending over the semiconductor region in a second direction different from the first direction;
a dielectric layer beneath the gate structure; and
a subregion beneath the semiconductor region, wherein the subregion extends through at least a portion of a thickness of the dielectric layer, and wherein the subregion comprises a material having a thermal conductivity of at least 1.5 W/m·K.

2. The integrated circuit of claim 1, wherein the material substantially fills the subregion such that a bottom surface of the material is substantially coplanar with a bottom surface of the dielectric layer.

3. The integrated circuit of claim 1, wherein the material substantially fills the subregion and extends below a bottom surface of the dielectric layer.

4. The integrated circuit of any one of claims 1 through 3, wherein the material is a liner material on outside surfaces of the subregion, and the subregion further comprises a fill material on the liner material.

5. The integrated circuit of claim 4, wherein the liner material is also on a bottom surface of the dielectric layer.

6. The integrated circuit of claim 4 or 5, wherein the liner material comprises boron and nitrogen.

7. The integrated circuit of any one of claims 1 through 6, wherein the material comprises aluminum and nitrogen.

8. The integrated circuit of any one of claims 1 through 6, wherein the material comprises silicon and carbon.

9. The integrated circuit of any one of claims 1 through 8, wherein the semiconductor region is a first semiconductor region and the source or drain region is a first source or drain region, the integrated circuit further comprising:
a second semiconductor region extending from a second source or drain region in the first direction, the second source or drain region being adjacent to the first source or drain region along the second direction;
a first contact on a top surface of the first source or drain region;
a second contact on a top surface of the second source or drain region; and
a material layer between the first contact and the second contact, the material layer having a thermal conductivity of at least 1.5 W/m·K.

10. The integrated circuit of claim 9, wherein the material layer comprises silicon and nitrogen or comprises silicon and carbon.

11. The integrated circuit of claim 9, wherein the material layer comprises aluminum and nitrogen or comprises aluminum and oxygen.

12. The integrated circuit of any one of claims 9 through 11, wherein a top surface of the material layer is substantially coplanar with a top surface of the first and second contacts.

13. The integrated circuit of any one of claims 1 through 12, further comprising a contact over a top surface of the source or drain region, wherein the contact extends through at least 50% of an entire height of the source or drain region.

14. The integrated circuit of claim 13, wherein the contact extends through an entire height of the source or drain region.

15. A die that includes the integrated circuit of any one of claims 1-14.
